(19) Europäisches Patentamt European Patent Office Office européen des brevets

(11) **EP 4 446 459 A1**

(12) **EUROPEAN PATENT APPLICATION**

(43) Date of publication:
**16.10.2024 Bulletin 2024/42**

(21) Application number: **23167268.4**

(22) Date of filing: **11.04.2023**

(51) International Patent Classification (IPC):
**C23C 14/24** $^{(2006.01)}$     **C23C 14/54** $^{(2006.01)}$

(52) Cooperative Patent Classification (CPC):
**C23C 14/243; C23C 14/246; C23C 14/543**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **NEOVAC GmbH**
**63791 Karlstein (DE)**

(72) Inventors:
• **ENGLERT, Ulrich**
**63791 Karlstein (DE)**
• **HERZOG, André**
**63791 Karlstein (DE)**
• **SAUER, Peter**
**36381 Schlüchtern (DE)**

(74) Representative: **Weilnau, Carsten et al**
**Patentanwälte Sturm Weilnau Franke**
**Partnerschaft mbB**
**Unter den Eichen 5 (Haus C-Süd)**
**65195 Wiesbaden (DE)**

(54) **EVAPORATION CRUCIBLE AND EVAPORATION UNIT**

(57)     The present disclosure relates to an evaporation crucible (40) for arrangement inside an evaporation chamber (50) and for evaporating a metallic evaporation material, the evaporation crucible (40) comprising:
- an evaporation cavity (55) comprising a liquid storage section (57) and an evaporation section (58) adjoining the liquid storage section (57) from above, wherein the evaporation cavity (55) is confined by a sidewall (41) and a bottom (42) adjoining the sidewall (41),
- an inlet (56) in fluid connection with the evaporation cavity (55), extending through or into the bottom (42) and fluidically connectable to a fluid connection (30) to supply a molten evaporation material (12) into the evaporation cavity (55),
- wherein in the region of the liquid storage section (57) a horizontal cross-sectional area of the evaporation cavity (55) reduces in size towards the inlet (56) or bottom (42).

Fig. 5

EP 4 446 459 A1

**Description**

The present invention relates to the field of coating substrates, and in particular to the field of coating metallic substrates with a metallic coating or anti-corrosive coating. In further aspects the present invention relates to an evaporation unit, a coating arrangement a method of determining a fill level of a molten evaporation material inside an evaporator.

Background

Coating materials, such as a gaseous metal or metallic layers may be coated on a surface of a metallic substrate, such as a single sheet or steel strip. Here, the substrate is arranged in a coating- or vacuum atmosphere. In vacuum deposition there may be applied various deposition methods, by way of which a solid or liquid coating material, e.g. a metallic coating material, is evaporated. This typically implies a heating of the evaporation material up to an evaporation temperature, e.g. in a vacuum atmosphere, to transition into a gaseous or evaporated state. Once the evaporation material is sufficiently evaporated a thin-film is formed on the substrate as a coating.

Typically and for physical vapor deposition (PVD) of substrates on a rather large scale it is quite challenging to control a deposition rate of an evaporator located inside the vacuum atmosphere. Furthermore, it is quite challenging to provide a sufficient and/or constant supply of molten evaporation material to the evaporator and hence into the evaporation chamber.

For instance, document EP 3 812 481 A1 discloses an operation arrangement comprising a first and a second crucible that are fluidically connected. The first crucible can be arranged inside a vacuum chamber and the second crucible can be arranged outside the vacuum chamber. With this evaporation arrangement a fill level of the first crucible is controlled by controlling a gas pressure in the second crucible.

Modifying of a gas pressure in or with the second crucible outside the vacuum chamber is quite challenging and requires installation and precise controlling of respective equipment to provide a sufficient and precise fluid level control. In addition, the demand of modifying a gas pressure in the second crucible is detrimental to supply further material or evaporation material into the crucible without interrupting the coating process.

It is therefore desirable to provide improvements to an evaporation unit for evaporating a metallic evaporation or coating material, which improvements provide a rather easy and straightforward control of a fill level of molten evaporation material inside an evaporation crucible, which is arranged inside an evaporation chamber. It is also desirable to enable and/or to provide a rather easy and straightforward way of supplying evaporation or coating material to the respective crucible.

It is also quite challenging and demanding to precisely control a fill level of liquid molten evaporation material in an evaporation crucible or evaporator inside a vacuum chamber. The temperature inside the vacuum chamber may be in a range of more than 500°C thus making it difficult to have electrical or electronically operated sensors inside the vacuum chamber.

Moreover, transferring of electrical signals from inside the vacuum chamber to a controller located outside the vacuum chamber is quite difficult and demanding. Furthermore, fill level sensors arranged inside a vacuum chamber may be subject to continuous deposition of evaporation material as the evaporation unit is in use. Insofar, a sensor or sensing arrangement inside an evaporation chamber to determine or to measure a fill level of a molten material in an evaporator may either require regular maintenance or may exhibit only a limited lifetime.

It is therefore desirable to provide an improved evaporation unit that allows to precisely measure or to precisely determine a fill level of an evaporation material inside an evaporation crucible without making use of measuring equipment inside the evaporation chamber.

Summary

In a first aspect the present disclosure relates to an evaporation crucible for arrangement inside an evaporation chamber and for evaporating a metallic evaporation material. The evaporation crucible comprises an evaporation cavity. The evaporation cavity comprises a liquid storage section and an evaporation section adjoining the liquid storage section from above. The evaporation cavity is confined by a sidewall and a bottom adjoining the side wall. The evaporation crucible further comprises an inlet in fluid connection with the evaporation cavity. The inlet extends through or into the bottom and is fluidically connectable to a fluid connection to supply a molten evaporation material into the evaporation cavity.

In the region of the liquid storage section a horizontal cross-sectional area of the evaporation cavity reduces in size towards the inlet or bottom. Accordingly, and by providing a liquid storage section with a horizontal cross-sectional area that reduces in size towards the inlet or bottom, a size of a surface of the molten evaporation material adjoining the evaporation section and hence forming or constituting a boundary between the liquid state and the gaseous state of the evaporation material can be varied by a modification of the fluid level or fill level of the molten evaporation material inside the evaporation cavity.

With a decreasing horizontal cross-sectional area of the evaporation cavity towards the inlet or bottom of the evaporation cavity the size of the surface of the molten evaporation material from which surface the molten evaporation material can transition into the gaseous state, can be modified, by way of which, an evaporation rate of the evaporation crucible and hence of an evaporator equipped with such an evaporation crucible can be varied. Insofar, the design and the geometric shape of the evaporation crucible and hence of the evaporation cavity is beneficial to provide a rapid and precise modification of an evaporation rate according to which molten evaporation material transitions into evaporated material or into the gaseous state inside the evaporation cavity.

In effect and simply by reducing the filling level of the molten evaporation material inside the evaporation cavity the size of the surface of the molten and hence liquid evaporation material is automatically reduced, thereby reducing the rate at which the molten evaporation material transitions into the gaseous state. Insofar, the geometric shape of the evaporation cavity, e.g. converging towards the inlet or bottom, provides an effective tool to modify an evaporation rate of an evaporation crucible even independent of a temperature to which the evaporation crucible is heated or exposed to.

The evaporation cavity may be virtually separated in the liquid storage section and the evaporation section. The liquid storage section may be completely occupied by a molten and hence liquid evaporation material when the evaporation crucible and hence the evaporation cavity is in use. The evaporation section may be entirely occupied by evaporated or gaseous evaporation material. It may be defined by the residual volume of the evaporation cavity that is occupied by the gaseous evaporation material when the evaporation crucible is in use.

Insofar, the liquid storage section is always below the evaporation section of the evaporation cavity. In other words, the evaporation section of the evaporation cavity is located above the liquid storage section and may occupy the entire residual space of the evaporation cavity, which is unoccupied by the molten or liquid evaporation material. Typically, an upper surface of the molten evaporation material located inside the evaporation cavity defines an interface or boundary between the liquid storage section and the evaporation section.

In some examples the inlet is attached to or fluidically connected to a bottom or bottom side of the evaporation cavity. This way, the evaporation cavity can be filled or supplied with molten evaporation material from below. Vice versa, the evaporation cavity can be emptied also through the inlet, e.g. in case that the evaporation crucible or evaporation cavity should be subject of a maintenance procedure.

In some examples the inlet is in permanent fluid connection with a melting crucible, which may be arranged outside the evaporation chamber. The melting crucible may provide a storage of molten evaporation material and may be permanently in fluid connection with the evaporation crucible through the fluid connection.

In some examples, the volume of the melting crucible is larger than the volume of the evaporation crucible. In some examples the volume of the melting crucible, and hence the volume of the melting cavity is twice as large as the volume of the evaporation crucible. In some examples, the volume of the melting cavity is at least three times, at least four times, at least five times as large as the volume of an evaporation cavity of the evaporation crucible. In this way, the melting crucible can be also used as a storage crucible operable to store and/or to provide a comparatively large amount of molten evaporation material, which upon demand and depending on the evaporation rate at which molten evaporation material transitions into the gas phase and hence into an evaporated state with the evaporation crucible, can be supplied to the evaporation crucible.

According to a further example the sidewall of the evaporation cavity comprises a lower sidewall section confining at least a portion of the liquid storage section. The lower sidewall section comprises a horizontal cross-sectional area that reduces in size towards the inlet or bottom. In other words, an upper portion or upper end of the lower sidewall section, being located comparatively far away from the bottom or inlet, comprises or confines a first horizontal cross-sectional area. A lower portion of the lower sidewall section being closer towards the inlet or bottom comprises or confines a second horizontal cross-sectional area. Here, the second horizontal cross-sectional area is smaller than the first horizontal cross-sectional area. As a liquid level of molten evaporation material drops from e.g. the upper portion of the lower sidewall section towards the lower portion of the lower sidewall section the interface or boundary, hence the surface of the molten evaporation material adjoining the liquid storage section reduces accordingly, thereby inherently reducing an evaporation rate, at which evaporation material can transition from the liquid state into the gaseous state.

According to another example the lower sidewall section comprises a funnel-shaped portion with a decreasing cross-sectional area towards the inlet or bottom. Hence, the horizontal cross-sectional area of the lower sidewall section may constantly, continuously and/or steplessly decrease towards the inlet or bottom. It may gradually decrease or it may decrease in discrete steps. The size reduction of the cross-sectional area towards the inlet or bottom may be a function of the vertical distance from the inlet or bottom. Here, the closer the fill level of the alternate evaporation material is to the inlet or bottom the smaller will be the surface of the molten evaporation material adjoining the evaporation section of the evaporation cavity.

In some examples, the funnel-shaped portion may be a two-dimensional geometric narrowing structure. Here, the sidewall may comprise a first sidewall portion and a second sidewall portion, both of substantially planar shape and arranged opposite to each other. Towards the inlet or bottom, the horizontal distance between the first and the second sidewall portions may decrease so as to reduce the horizontal cross-sectional area of the evaporation cavity.

Here, the first and the second sidewall portions may be connected by third and fourth sidewall portions, respectively, wherein the third and fourth sidewall portions may extend substantially parallel to each other and interconnect opposite ends of the first and the second sidewall portions.

In effect, the sidewall or lower sidewall of the evaporation cavity may comprise one of a two-dimensional or three-dimensional trapezoidal structure. It may comprise a pyramidal structure with a rectangular or quadratic cross-section. It may comprise a structure like a frustrum of a pyramid or pyramid-like geometric structure.

Specifically, and with a three-dimensional trapezoidal structure at least one of the third and the fourth sidewall portions may also be inclined at a predefined angle relative to each other or relative to a vertical orientation, such that a horizontal distance between the third and the fourth side wall sections decreases towards the bottom or inlet.

According to a further example the lower sidewall section comprises a curved or concave shaped portion with a decreasing cross-sectional area towards the inlet or bottom. Such a curved or concave shaped portion of the sidewall section may provide a well-defined functional relationship between an evaporation rate and a fill level of molten evaporation material inside the evaporation cavity when the fill level is in the region of the curved or concave shaped portion. A degree of varying an evaporation rate in dependence of a variation of the fill level can be thus varied by the specifically curved or concave shaped profile of the lower sidewall section.

With a comparatively steep inclined section of the lower sidewall section, e.g. approaching an almost vertical orientation the effect of a variation of the fill level on the evaporation rate is comparatively low. With a comparatively shallow slope or inclination of the lower sidewall section, e.g. only rising slightly more than 10° relative to a virtual horizontal line, the change in the evaporation rate depending on the fill level is comparatively large. Here, already with a comparatively small variation of the fill level the horizontal cross-sectional area of the molten evaporation material may change drastically.

According to another example the lower sidewall section adjoins or merges into the bottom. In some examples the lower sidewall section may even form the bottom.

In some examples, the evaporation crucible may be even bottomless and the lower sidewall section may directly adjoin or merge into the inlet. Here, the inlet may form the bottom or may coincide with the bottom of the evaporation cavity.

According to a further example the lower sidewall section of the evaporation cavity at least in sections comprises a surface normal extending at an angle at an angle $\alpha$ with respect to a horizontal line, wherein $\alpha > 0°$, $\alpha > 10°$, $\alpha > 15°$, $\alpha > 20°$, $\alpha > 30°$, $\alpha > 45°$ or wherein $\alpha > 60°$ and/or wherein $80° > \alpha > 10°$, $70° > \alpha > 20°$, $60° > \alpha > 30°$, $50° > \alpha > 40°$, or wherein $\alpha$ is about 45°.

By way of example and when $\alpha$ is about 45° a modification of the vertical filling level almost equally reflects in a respective modification of a horizontal extent or diameter of the cross-sectional area occupied by the surface of the molten evaporation material. With $\alpha$ being smaller than 45° a variation of the fill level of the molten evaporation material has a smaller effect on the cross-sectional area of the liquid surface. With $\alpha$ larger than 45° the dependency of a horizontal size variation of the surface of the liquid molten evaporation material on the liquid level or fill level increases.

According to a further example the evaporation crucible is operable to transition molten evaporation material in the liquid storage section into evaporated material evaporated into the evaporation section as long as a fill level of molten evaporation material in the liquid storage section is above a predefined minimum fill level and is below a predefined maximum fill level.

The evaporation crucible comprises well-defined markings with regards to a minimum fill level and a maximum fill level in order to provide and/or to generate evaporated evaporation material from the molten evaporation material stored or provided in the liquid storage section. In operation of the evaporation crucible and when generating evaporated evaporation material from molten evaporation material the fill level or liquid level of the molten evaporation material must not drop below the predefined minimum fill level. Otherwise, the evaporation crucible may overheat and/or the entire coating arrangement may be operated in an undue or dangerous configuration.

According to a further example a horizontal cross-sectional area of the sidewall at the predefined maximum fill level is larger than a horizontal cross-sectional area of the sidewall of the predefined minimum fill level. Typically, the lower sidewall section of the sidewall, which may be inclined with respect to the vertical and/or with respect to the horizontal axis or direction may be located between an upper portion of the sidewalk coinciding with the maximum fill level and a lower portion of the sidewall effectively coinciding with the minimum fill level.

The minimum fill level and hence the lower portion of the sidewalk coinciding with the fill level of the evaporation cavity may be located in the lower sidewall section, which comprises at least one of a funnel-shaped portion, a curved and a concave shaped portion.

In effect and since the horizontal cross-sectional area of the sidewall at the predefined maximum fill level is larger than a horizontal cross-sectional area of the sidewall at the predefined minimum fill level the evaporation cavity provides a number of horizontal cross-sectional areas of different size, which can be occupied by molten evaporation material depending on the fill level of the evaporation material in the evaporation cavity.

According to a further example the evaporation rate, at which molten evaporation material is transitionable into evaporated material inside the evaporation cavity is adjustable by modifying the filling level of the molten evaporation material in the liquid courage section. Modifying the filling level of the molten evaporation material in the liquid storage section may be easily and rather rapidly obtained by inverting the function of the inlet. Here, the molten evaporation material in the liquid storage section may exit from the evaporation cavity through the inlet and through the fluid connection in a direction opposite to an filling direction through which the evaporation cavity was previously filled with liquid molten evaporation material. By draining the molten evaporation material rather from the evaporation cavity the evaporation rate and hence the amount of evaporated evaporation material inside the evaporation chamber can be reduced to a minimum rather rapidly and instantly.

In addition, the evaporation rate may be also adjusted or controlled by varying a temperature of the evaporation crucible or evaporation cavity. Hence, the evaporation crucible may be part of an evaporator or evaporator arrangement, which evaporator comprises at least the evaporation cavity and a suitable heating to heat the molten evaporation material inside the evaporation cavity to such a degree that the molten evaporation material transitions into the gas phase.

In another aspect the present disclosure relates to an evaporation unit for evaporating a metallic evaporation material. The evaporation unit comprises an evaporation crucible as described above, which is configured to be arranged or to be inserted or being actually arranged inside an evaporation chamber, e.g. implemented as a vacuum chamber. The evaporation unit further comprises a melting crucible outside the evaporation chamber and fluidically connected with the evaporation crucible. The melting crucible comprises a melting cavity to melt the metallic evaporation material, to store and/or to heat molten evaporation material. The melting crucible may be implemented as described above. The volume of the melting crucible may be substantially larger than the volume of the evaporation crucible.

The evaporation unit further comprises a liquid level adjuster, which is coupled with at least one of the melting crucible and the evaporation crucible and which is operable to vary a level of molten evaporation material inside the evaporation cavity.

In a further example of the evaporation unit the liquid level adjuster is coupled with the melting crucible and is operable to vary a level of the molten evaporation material inside the melting cavity with respect to a ground and/or with respect to a sidewall of the melting crucible to thereby vary a filling level of molten evaporation material in the liquid storage section of the evaporation crucible for adjusting or controlling an evaporation rate, at which molten evaporation material transitions into evaporated material inside the evaporation cavity. A rise in the liquid level of molten material in the melting crucible equally transfers into a respective modification of the liquid level of molten evaporation material in the evaporation crucible.

According to a further example a fill level of molten evaporation material inside the evaporation crucible is adjustable by varying the level or height of the molten evaporation material in the melting crucible. For this, either the liquid level of the molten evaporation material inside the melting crucible can be varied relative to the melting crucible or sidewall of the melting crucible. Alternatively or additionally, the position of the entire melting crucible can be varied with regard to the vertical direction. Hence, a height of the melting crucible and hence a respective height of the liquid level of the molten evaporation material stored or contained therein can be modified in this way. In either way, a modification of the liquid level of the molten evaporation material inside the melting crucible can be used to control and/or to modify the liquid level or filling level of the molten evaporation material inside the evaporation crucible.

In a further example the liquid level adjuster comprises one of a lifting device and a displacement body. The lifting device support the melting crucible and is operable to modify and/or to adjust a height of melting crucible relative to a ground. In other examples and wherein the liquid level adjuster comprises a displacement body, the displacement body is variably immersible into the molten evaporation material inside the melting crucible to thereby vary a level of the molten evaporation material inside the cavity with respect to the sidewall of the evaporation crucible.

In either way, the liquid level of molten evaporation material inside the melting crucible can be adjusted or modified, which due to the fluidical connection with the evaporation crucible also transfers or transitions into a respective variation or modification of the fill level of the molten evaporation material in the evaporation crucible.

According to a further example the evaporation crucible comprises an outlet. The outlet is provided at an upper portion of the sidewall and adjoins the evaporation section. The outlet is typically provided with a nozzle or nozzle section, e.g. extending outwardly from the sidewall of the evaporation crucible. The nozzle section defines an inner cross-section, which reduces towards the outlet of the evaporation crucible. In this way, there can be provided a kind of an acceleration of evaporated material and hence a kind of a jet effect towards the outlet.

In another aspect the present disclosure also relates to a coating arrangement for coating a substrate with a metallic material through vapor deposition, e.g. physical vapor deposition. The coating arrangement comprises an evaporation chamber to receive the substrate and further comprises an evaporation unit as described above. The evaporation unit comprises an evaporation crucible arranged inside the evaporation chamber. The melting crucible of the evaporation unit is arranged outside the evaporation chamber of the coating arrangement. It may be exposed to atmospheric pressure, which facilitates supply of evaporation material into the melting crucible during a coating process.

In some examples the evaporation chamber is a vacuum chamber. It is coupled with a vacuum pump by way of which a vacuum and hence a vacuum pressure can be generated inside the evaporation chamber. The evaporation crucible is also subject to the vacuum pressure inside the evaporation chamber. The evaporation crucible is fluidically connected to the melting crucible. It may be arranged at a higher level compared to the melting crucible. Since the evaporation crucible is exposed to a vacuum pressure and since the melting crucible may be exposed to atmospheric pressure, the evaporation crucible inside the evaporation chamber may be arranged at a level substantially higher than the melting crucible outside the evaporation chamber. The difference in pressure may directly reflect in a difference in height or vertical level between the liquid level of molten evaporation material inside the melting crucible and a liquid level of molten evaporation material inside the evaporation crucible.

Arranging of the evaporation crucible above the melting crucible is also of particular benefit in case that the evaporation crucible and/or the evaporation chamber to become subject to maintenance. Emptying of the evaporation crucible may be exclusively obtained under the effect of gravity, whereby the molten evaporation material located inside the evaporation crucible simply flows through the fluidical connection back into the melting crucible.

In some examples the substrate comprises a sheet of steel or metal. In other examples the substrate comprises a continuous strip or band of metal or steel to be coated with a metallic or metallic alloy evaporation material comprising at least one or a combination of the following materials: zinc, aluminum, nickel, chrome, magnesium or titanium.

In some examples the coating arrangement is configured to coat a surface of the substrate with an anti-corrosive layer or anti-corrosive coating. In some examples, the vacuum coating system is configured for coating a band-type metallic substrate, such as a steel, with a metallic material or metallic alloy comprising at least one or a combination of at least one or more of the following materials: zinc, aluminum, nickel, chrome, magnesium or titanium, e.g. by way of physical vapor deposition (PVD).

Since the coating arrangement comprises an evaporation unit as described above, all features, effects and benefits as described above in connection with the evaporation unit equally apply to the coating arrangement; vice versa.

In still another aspect the present disclosure also relates to a method of adjusting or controlling an evaporation rate of an evaporation unit configured to evaporate a metallic evaporation material. The evaporation unit comprises an evaporation crucible as described above. The evaporation crucible is arrangeable or is arranged inside an evaporation chamber, e.g. a vacuum chamber of a coating arrangement, e.g. as described above.

The method of adjusting or controlling the evaporation rate comprises varying of a fill level of molten evaporation material in a liquid storage section of an evaporation cavity of an evaporation crucible as described above. Since the liquid storage section comprises a horizontal cross-sectional area that reduces in size towards an inlet, towards a bottom or a bottom side, the size of the surface of the molten evaporation material in the liquid storage section can be modified by varying the fill level of the liquid storage section of the evaporation cavity. The method of adjusting or controlling the evaporation rate of the evaporation unit is particularly executable by making use of an evaporator and/or by an evaporation crucible as described above. Insofar, all features, effects and benefits described above in connection with the evaporation crucible equally apply to the method of adjusting or controlling the evaporation rate.

Typically, and for operating the evaporation unit or evaporation crucible in an evaporating mode, the liquid storage section of the evaporation cavity is filled with a molten evaporation material at least to a predefined minimum fill level. Hence, for adjusting or controlling the evaporation rate the liquid storage section of the evaporation cavity is filled with a molten evaporation material to such an extent, that the fill level of the evaporation cavity is at or above a predefined minimum fill level and below a predefined maximum fill level.

When filled to a minimum fill level the upper surface of the molten evaporation material in the evaporation cavity is at a minimum fill level section or minimum fill level marking of the sidewall of the evaporation cavity. When filled to a maximum fill level the upper surface of the molten evaporation material is at a maximum fill level section or maximum fill level marking of the sidewall of the evaporation cavity.

Between the minimum fill level marking and the maximum fill level marking the sidewall comprises at least one of an inclined or curved sidewall section, such that the horizontal cross-sectional area at the minimum fill level marking of the sidewall comprises a first size. At the maximum fill level marking the sidewall comprises a horizontal cross-sectional area of a second size. The second size is larger than the first size. The maximum marking and/or the minimum marking may be only nominal and may not be present physically. Respective (and even virtual markings may only reflect or coincide with a predefined maximum or minimum fill level.

Typically, and according to a further example, the evaporation crucible or the evaporator comprising the evaporation crucible comprises a heating by way of which the temperature inside the evaporation cavity can be controlled. The heating may be adjusted or controlled by a controller so as to rise the temperature to or above an evaporation temperature inside the evaporation chamber that leads to a significant evaporation rate of the molten evaporation material as stored in the evaporation cavity.

Controlling of the evaporation rate is typically provided by two parameters, namely by the fill level of molten evaporation material inside the evaporation cavity and by the thermal energy provided by the heating, i.e. by the temperature of the evaporation cavity and/or by the resulting temperature of the molten evaporation material. Of course, the vacuum pressure inside the evaporation or vacuum chamber also has a respective and known influence on the evaporation rate.

According to a further example the evaporation rate, at which molten evaporation material transitions into evaporated material inside the evaporation cavity is raised by increasing the fill level of molten evaporation material in the liquid storage section. Concurrently, the evaporation rate is lowered by decreasing the fill level of more than evaporation material in the liquid storage section.

Particularly and for lowering or reducing an evaporation rate it is quite effective to reduce the fill level of molten evaporation material inside the evaporation cavity. Concurrently, thermal energy as provided by the heating can be reduced. In this way, a rather fast and immediate reduction of the evaporation rate can be achieved.

In addition, and by modifying the fill level of the molten evaporation material inside the evaporation cavity there can be provided a rather precise adjustment of an evaporation rate, namely by gradually modifying the size of the surface of the molten evaporation material, which is adjacent to the evaporation section of the evaporation cavity.

According to a further example the evaporation unit further comprises a melting crucible outside the evaporation chamber. The melting crucible is fluidically connected with the evaporation crucible. The fill level of molten evaporation material in the liquid storage section of the evaporation cavity is and can be varied by modifying a level of the molten evaporation material inside a melting cavity of the melting crucible with respect to a ground and/or with respect to a sidewall of the melting crucible.

Typically, the melting crucible and the evaporation crucible are permanently fluidically connected. This way, the fill level of an alternative operation material located inside the melting crucible is always correlated to a respective fill level of molten evaporation material inside the evaporation crucible. By raising or lowering the fill level of molten evaporation material in the melting crucible a respective rise or reduction of the fill level of molten evaporation material in the evaporation crucible be achieved. This way and since the melting crucible is located outside the evaporation chamber there is provided a rather effective control mechanism to modify, to regulate and/or to control the fill level and hence the evaporation rate of the evaporator or evaporation crucible from outside the evaporation chamber, even independent of a temperature regulation of the evaporation crucible.

Brief Description of the Drawings

In the following, numerous examples of the evaporation unit, the coating arrangement and a method of deriving or determining a fill level of molten evaporation material are described in greater detail by making reference to the drawings, in which:

Fig. 1  schematically illustrates a coating arrangement with an evaporation unit,

Fig. 2  schematically shows a further example of an evaporation unit,

Fig. 3  schematically shows a further example of an evaporation unit,

Fig. 4  schematically shows details of an example of the melting crucible,

Fig. 5  shows an example of an evaporation crucible,

Fig. 6  shows another example of an evaporation crucible,

Fig. 7  shows a further example of an evaporation crucible,

Fig. 8  shows a block diagram of the evaporation unit and coating arrangement,

Fig. 9  schematically illustrates a three-dimensional view of a portion of an evaporation crucible according to Fig. 5,

Fig. 10  is a flowchart of a method of deriving or determining a fill level of molten evaporation material and

Fig. 11  is a flowchart of a method of adjusting or controlling an evaporation rate of an evaporation unit.

Detailed description

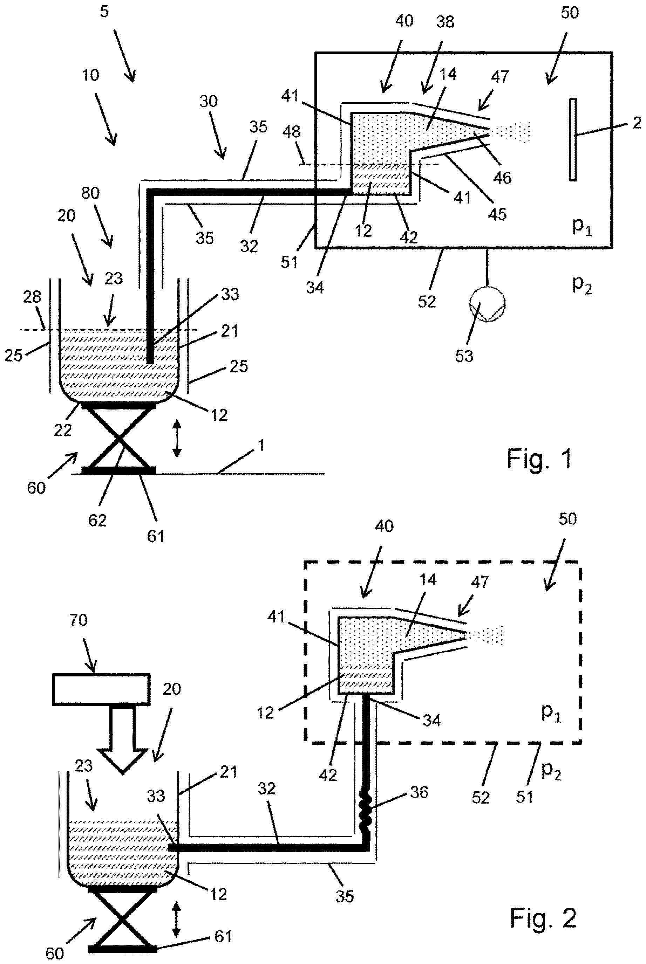

In Figs. 1-9 there are illustrated numerous examples of a coating arrangement 5 comprising an evaporation unit 10. The coating arrangement 5 may be implemented to coat a metallic substrate with a metallic material. The coating arrangement 5 may be particularly configured to coat strips or sheets of steel with an anti-corrosive coating, e.g. comprising at least one or a combination of the following materials: zinc, aluminum, nickel, chrome, magnesium or titanium.

The coating arrangement 5 is configured to evaporate a molten evaporation material 12 and to generate evaporated material 14, which is applied to the surface of the substrate 2. The coating arrangement 5 is configured to coat the substrate 2 via vapor deposition, in particular via physical vapor deposition.

The coating arrangement 5 comprises an evaporation unit 10. The evaporation unit 10 comprises an evaporation crucible 40 inside the evaporation chamber 50. The evaporation unit 10 further comprises a melting crucible 20 outside the evaporation chamber 50 and fluidically connected with the evaporation crucible 40. The fluidic connection between the melting crucible 20 and the evaporation crucible 40 is provided by a fluid connection 30. The fluid connection 30 comprises a fluid guiding pipe 32, which is provided with a heating 35. The fluid connection 30 comprises an end section 33, which is immersed in molten evaporation material 12 provided or stored in the melting crucible 20. The fluid connection 30 and hence the pipe 32 comprises an opposite longitudinal end section 34, which is fluidically connected with the evaporation crucible 40.

By way of the fluid connection 30 the melting crucible 20 and the evaporation crucible 40 are permanently in fluid connection. Hence, a fill level 48 of the molten evaporation material 12 inside a melting cavity 23 of the melting crucible 20 always corresponds and/or correlates to a respective fill level 48 of molten of evaporation material 12 inside the evaporation crucible 40.

For melting of the evaporation material inside the melting cavity 23 and/or for storing molten evaporation material 12 inside the melting cavity 23 the melting crucible 20 is provided with a heating 25. The end section 33 of the fluid connection 30 is immersed into the molten evaporation material 12. This way, any impurities of the molten ever evaporation material 12 aggregating at a surface of the molten material 12 will be effectively hindered from entering the end section 33.

The evaporation crucible 40, which is located inside the evaporation chamber 50 is exposed to a reduced pressure, e.g. to a pressure at vacuum level. Particularly, the melting crucible 20 may be exposed to atmospheric pressure P2. The evaporation crucible 40 inside the evaporation chamber 50 is subject to a vacuum pressure p1. The evaporation crucible 40 is also provided with a heating 45 by way of which the molten evaporation material 12 in the evaporation crucible 40 can be heated to such an extent that a significant amount thereof transitions into evaporated material 14 and hence transitions into the gaseous phase. The gaseous evaporated material 14 may exit the evaporation crucible 40 through an outlet 46, which may be provided with a nozzle section 47 by way of which a jet or accelerated stream of evaporated material 14 impinges on the surface of the substrate 2.

The inside of the evaporation chamber 50 is coupled with a vacuum 53. The evaporation chamber 50 comprises a chamber wall 51 and forms or constitutes a vacuum chamber 52.

The fluid connection 30 extends through the chamber wall 51 and provides a permanent fluid communication between the evaporation crucible 40 and the melting crucible 20.

In some examples the melting crucible 20 serves to melt solid evaporation material, which may be supplied by a feeding unit 70 as indicated in Fig. 2. This way, there can be provided a constant supply of molten evaporation material 12 to the melting crucible 20 and hence to the evaporation crucible 40. It is of particular benefit, when the melting crucible 20 is located outside the evaporation chamber 50 and hence outside the vacuum chamber 52. It may be provided in a non-encapsulated configuration. It may be permanently exposed to atmospheric pressure. This provides a rather easy and straightforward supply of evaporation material to the melting crucible 20.

Due to the permanent fluid connection between the melting crucible 20 and the evaporation crucible 40 the fluid level or fill level 48 inside the evaporation crucible 40 can be adjusted by correspondingly adjusting the fill level 28 of molten evaporation material 12 in the melting crucible 20. Moreover, and since the pressure p1 is lower than the pressure p2 the melting crucible 20 may be located at a height below the evaporation crucible 40. A difference in height $\Delta h$ may be easily compensated by the pressure difference according to the following formula:

$$\Delta h = \left| \frac{p_1 - p_2}{\rho\, g} \right|$$

, with $g$ being the gravitational acceleration and $\rho$ as the density of the molten evaporation material 12.

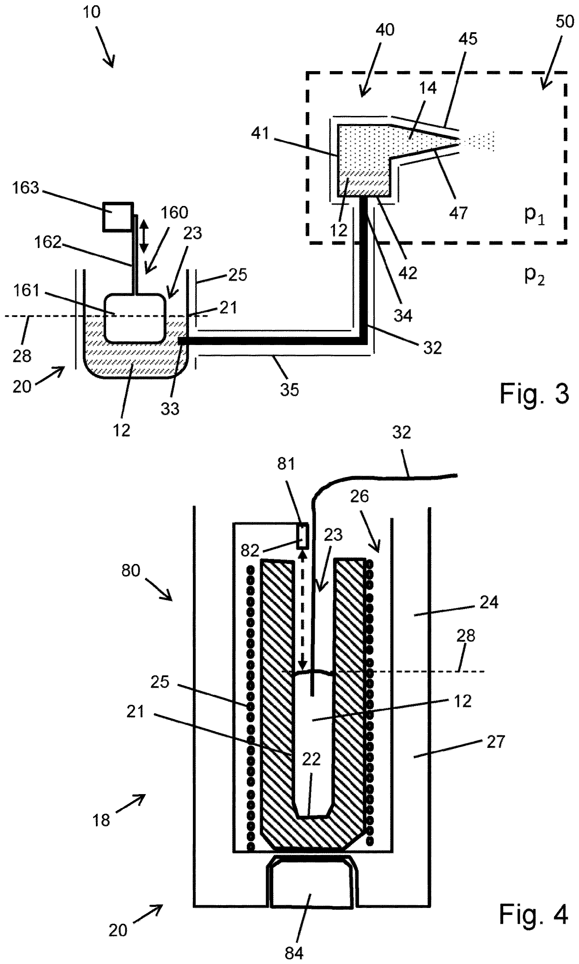

For regulating or controlling the fill level 48 inside the evaporation crucible 40 the fill level 28 of the molten evaporation material 12 inside the melting crucible 20 is measured and adjusted. This can be provided by a liquid level adjuster 60 as illustrated in Figs. 1 and 2 or by a liquid level adjuster 160 as illustrated in Fig. 3. The liquid level adjuster 60 comprises a lifting device 61, by way of which the height or vertical position of the entire melting crucible 20 can be variedor adjusted. In the illustrated example the liquid level adjuster 60 comprises a scissor lift 62, which is controllable by a controller 90. Of course, this scissor lift 62 is operable by an electrical drive, which is operated or controlled by the controller 90. By raising or lowering the lifting device 61, the vertical position of the entire melting crucible 20 can be varied relative to a ground 1.

Accordingly, and by raising or lowering the melting crucible 20 the fill level 28 of the molten evaporation material 12 relative to the ground 1 can be varied and adjusted. Since the evaporation crucible 40 is fixed inside the evaporation chamber 50 a respective rise or lowering of the fill level 28 of molten evaporation material 12 in the melting crucible 20 has a respective effect on the fill level 48 of molten evaporation material 12 inside the evaporation crucible 40.

In Fig. 3 there is illustrated another example of a liquid level adjuster 160. Here, the liquid level adjuster 160 comprises a displacement body 161, which is configured to be immersed into the molten evaporation material 12 of the melting crucible 20. The liquid level adjuster 160 comprises a drive 163, which is also operable or controllable by the controller 90. The drive 163 is connected with the displacement body 161 through a connector 162. The connector 162 may comprise at least one of a rod and a chain. The displacement body may be a solid body made of a material, which comprises a melting temperature, which is above the melting temperature of the evaporation material 12 inside the melting cavity 23.

Moreover, the material of the displacement body 161 may comprise a higher density compared to the density of the molten evaporation material 12. This way, the displacement body 161 may easily immerse or submerge into the molten evaporation material 12 under the effect of gravity.

By way of lowering or immersing the displacement body 161 into the molten evaporation material 12 the fill level 28 of the molten material 12 relative to a sidewall 21 of the melting cavity 23 can be increased, which leads to a respective modification and/or adjustment of the fill level 48 of molten evaporation material 12 inside the evaporation crucible 40.

With the example of Fig. 1 the melting crucible 20 is open towards the top and the fluid connection 30 with the pipe 32 extends into the molten evaporation material 12 from above. Here and by raising or lowering the melting crucible 20 with the lifting device 61 only the immersion depth of the end section 33 of the pipe 32 is varied.

With the alternative examples as shown in Figs. 2 and 3 the pipe 32 extends through a lower portion of the sidewall 21 of the melting cavity 23 and the end section 33 of the pipe 32 may extend through the side wall 21 near a bottom 22 of the melting cavity 23.

In the example of Fig. 2 and with a liquid level adjuster 60 comprising a lifting device 61 the pipe 32 may comprise a flexible portion 36 in order to compensate varying heights between the oppositely located end sections 33 and 34 of the pipe 32. With the example of Fig. 2, the end section 43 of the pipe 32 extends through a bottom 42 of the evaporation crucible 40. In the example of Fig. 1 the end section 34 extends through a lower portion of a sidewall 41 of the evaporation crucible 40 adjacent, near or close to the bottom 42. The example of a liquid level adjuster 160 according to Fig. 3 may be beneficial for such examples of the coating arrangement 5 or evaporation unit 10, where the melting crucible 20 comprises a significant mass or weight.

The evaporation unit 10 further comprises a measuring arrangement 80 which is coupled to the melting crucible 20 and which is operable to quantitatively measure at least one of a fill level 28 of molten evaporation material 12 in the melting cavity 23 and a mass of molten evaporation material 12 in the melting crucible 20 or melting cavity 23. For this, the measuring arrangement 80 comprises at least one of a liquid level detector 81 and a scale 84 as illustrated in Fig. 4.

In Fig. 4 there is shown a melting unit 18 comprising the melting crucible 20. The melting unit 18 comprises a carrier 24 or chassis comprising or forming a receptacle 26 sized to receive or to accommodate the melting crucible 20. Inside the receptacle 26 the melting crucible 20 is arranged. The melting crucible 20 comprises a cup-shaped melting cavity 23. A bottom and/or or a sidewall of the melting cavity 23 is cladded by or provided with a thermal insulation 27. The thermal insulation 27 and/or the melting cavity 23 are thermally coupled with a heating 25 by way of which the content inside the melting cavity 23 can be heated and thus melted.

The receptacle 26 of the carrier 24 may comprise a bottom 22 on which the melting crucible 20 is positioned and supported. The entire carrier 24 may be arranged on a scale 48 in order to measure the weight of the entire melting crucible 20. Since the weight of the empty melting crucible 20 is constant a weight measurement of the melting crucible 20 with evaporation material 12 therein is directly indicative of the total weight and hence of the mass of the evaporation material 12.

The liquid level detector 81 may be installed or fixed to the carrier 24. In this way the position of the liquid level detector 81 relative to the melting crucible 20 and hence relative to the sidewall 21 is and remains constant. In other examples the liquid level detector 81 may be fixed to a base or to the ground 1. Here, the liquid level detector 81 may be operable to determined and/or to quantitatively measure an absolute level or height of the surface of the molten evaporation material 12 contained inside the melting cavity 23.

The liquid level detector 81 may comprise a distance meter 82 by way of which a distance between the surface of the molten evaporation material 12 and hence the fill level 28 relative to the sidewall 21 can be precisely measured. In some examples the liquid level detector 81 comprises a light source and a light detector to measure a distance between the liquid level detector and a surface of the molten evaporation material 12 in a reflection geometry. In some examples the liquid level detector comprises a laser-based distance measuring device.

In the presently illustrated example, wherein the measuring arrangement 80 comprises a both, a liquid level detector 81 and a scale 84, the amount or mass and hence the fill level 28 of molten evaporation material 12 inside the melting cavity 23 can be quantitatively determined or measured in a redundant way. By way of a redundant, i.e. twofold measurement of the fill level 28 in the melting cavity 23 the precision and reliability of a respective quantitative measurement can be improved. In addition, the measurement or determination of the fill level becomes rather failure safe.

The scale 84 as well as the liquid level detector 81 are coupled with the controller 90 in a signal transferring manner. Both, the scale 84 and the liquid detector 81 are configured to generate electrical measurement signals to be processed by the controller 90 in order to quantitatively determine the fill level 28 of molten evaporation material 12 inside the melting cavity 23.

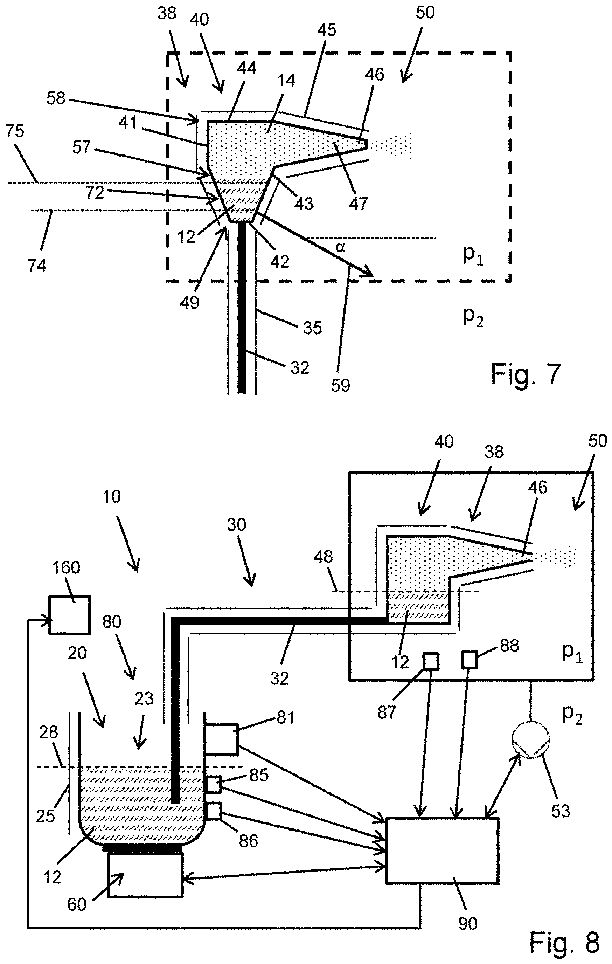

The measuring arrangement 80 may further comprise at least one of a temperature sensor 86 and a pressure sensor 85 as illustrated in Fig. 8. By way of a temperature sensor 86 the temperature of the molten evaporation material 12 inside the melting cavity 23 can be determined. Having knowledge of the weight of the molten evaporation material 12 inside the melting cavity 23 the fill level 28 can be precisely determined when taking into account the temperature dependency of the density of the evaporation material 12. Of course, the inner geometry of the melting cavity 23 is known.

The temperature sensor 86 may comprise a pyrometer and may be hence configured to contactlessly determine a temperature of the molten evaporation material 12, e.g. by arranging the temperature sensor 86 above the molten evaporation material 12.

The controller 90 is further connected to a pressure sensor 87 and a temperature sensor 88 located inside the evaporation chamber 50 or coupled with the evaporation chamber 50. By way of the pressure sensor 87 the vacuum pressure p1 inside the evaporation chamber 50 or vacuum chamber 52 can be quantitatively measured. In addition, also the temperature inside the evaporation chamber 50 and/or inside the evaporator 38 can be determined and/or quantitatively measured. The temperature sensor 86 may be also implemented as a pyrometer. The pressure sensor 87 may be either separately arranged inside the vacuum chamber 52 or may be integrated into the vacuum pump 53.

By quantitatively measuring the fill level 28 of the melting crucible 20 and by having knowledge of the momentary environmental pressure p2 and the vacuum pressure p1 inside the evaporation chamber 50 and further by having knowledge of a difference in height between the melting crucible 20 and the evaporation crucible 40 the fill level 48 of the molten evaporation material 12 inside the evaporation crucible 40 can be derived by the controller 90.

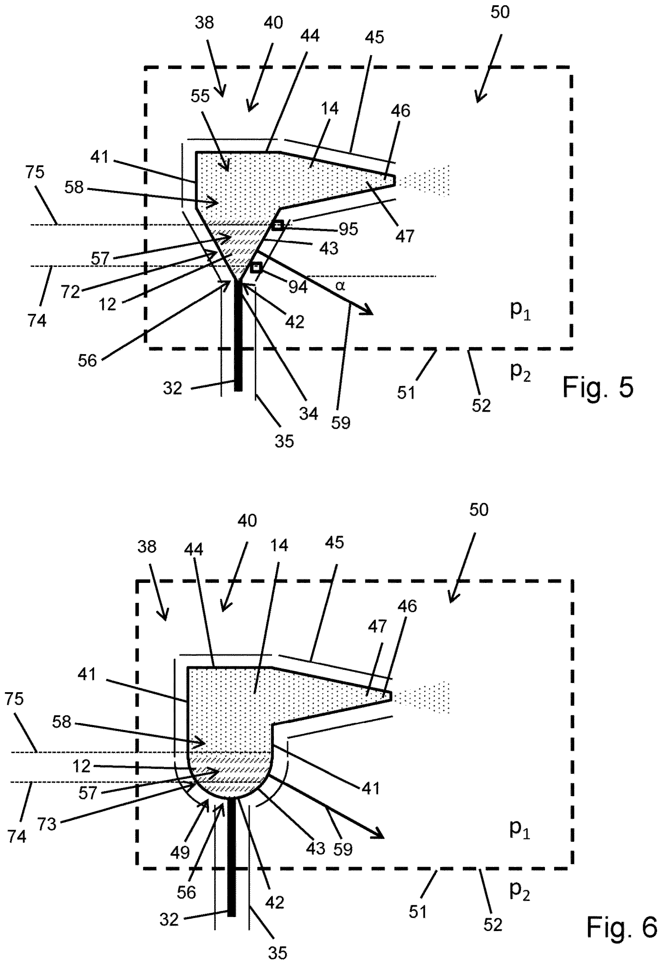

Of course, the evaporation units 10 and the measuring arrangement 80 are suitably calibrated. Initial calibration may be obtained by an initial filling of the evaporation crucible 40 with molten evaporation material 12 through the pipe 32 as indicated in Fig. 5. Here, the evaporation operation crucible 40 may be equipped with at least one fill level sensor 94, 95. In the present example there are schematically illustrated two fill level sensors 94, 95 at different height or at different vertical positions. The fill level sensor 94 may define or correlate with a minimum fill level 74 of the evaporation crucible 40. The fill level sensor 95 may define or may coincide with a maximum fill level 75. The fill level sensors 94, 95 may be implemented as electrical contact-based fill level sensors. Each one of the fill level sensors 94, 95 may comprise two electrical contacts, which are electrically connected by the electrically conductive evaporation material 12. Hence, the fill level sensors 94, 95 may be operable to simply detect the presence of evaporation material 12 and the position of the respective fill level sensors 94, 95.

During operation of the evaporator 38 the fill level sensors 94, 95 may not be of any further use. They may be connected in a signal transferring manner with the controller 90 to generate an alert signal just in case that the fill level 48 should drop below the minimum for level 74 or if the fill level 48 should exceed the maximum fill level 75.

Once the evaporation unit 10 and hence the measuring arrangement 80 has been properly calibrated knowledge of the pressure difference between p1 and p2 and the absolute height of the fill level 28 e.g. relative to ground 1 is generally sufficient to derive the fill level 48 of the evaporation material 12 inside the evaporation cavity 55 on the basis of a quantitative measurement of the fill level 28 measured under atmospheric pressure.

By constantly measuring the environmental pressure p2 or atmospheric pressure the controller 90 may even take notice of eventual modifications or fluctuations of the environmental pressure. In order to compensate for such pressure changes and/or in order to compensate the variations of the fill level 28, e.g. due to supply of non-molten or molten evaporation material into the melting crucible 20 the controller 90 is operable to operate the liquid level adjuster 60, 160, thereby artificially modifying the fill level 28 relative to ground 1 or relative to the sidewall 21 of the melting crucible 20 to maintain the fill level 48 within a predefined range.

Alternatively, the controller 90 is operable to vary the immersion depth of the displacement body 161 in the melting cavity 23.

The controller 90 may further control the heating 25, 35, 45 by way of which the evaporation material 12 is heated either inside the melting cavity 23, inside the fluid connection 30 or pipe 32 or inside the evaporation crucible 40.

In Figs. 5-9 there are illustrated numerous examples of an evaporator 38. The evaporator 38 comprises the evaporation crucible 40. The evaporation crucible 40 confines an evaporation cavity 55. The evaporation cavity 55 comprises a bottom side inlet 56 and an outlet 46 adjacent or close to a top 44. The outlet 46 may comprise an outwardly protruding nozzle section 47, with a converging or narrowing diameter or cross-section towards its free end.

Insofar, the nozzle section 47 is operable to accelerate a flow or stream of gaseous evaporation material 14 towards the substrate 2.

The evaporation crucible 40 comprises a bottom section 49 through which there is provided a fluidic connection with the pipe 32. The bottom section may comprise a bottom 42. The bottom 42 may be planar shape as shown in Fig. 7 or may comprise a curved profile as shown in Fig. 6. In the example of Fig. 5 a lower sidewall section 43 of the sidewall 41 adjoining the bottom 42 is of a funnel shape and merges into the end section 34 of the pipe 32. Here, the bottom 42 may be formed by the lower end of the inclined lower sidewall section 43.

The evaporation cavity 55 is separated into a liquid storage section 57 an evaporation section 58, which is located above the liquid storage section 57. In the present terminology the liquid storage section 57 is that part of the evaporation cavity 55, which is entirely occupied by molten or liquid evaporation material 12. The evaporation section 58 is located above the liquid storage section. The size of the liquid storage section 58 may increase with a supply of molten evaporation material 12 into the evaporation cavity 55. Increase of the liquid storage section 57 is always at the expense of the evaporation section; and vice versa. Hence, the size of the liquid storage section 57 varies oppositely to the size of the evaporation section 58.

In use of the evaporator 38 and when heated to a suitable and operating temperature the molten evaporation material your 12 located in the liquid storage section 57 evaporates into the evaporation section 58. The molten evaporation material 12 transitions into evaporated and hence gaseous evaporation material 14.

An evaporation rate at which molten evaporation material 12 undergoes a phase transition into a gaseous state depends on the temperature inside the evaporation chamber 50 and hence inside the evaporation crucible 40 as well as on the vacuum pressure $p_1$. The evaporation rate is further dependent on the available size of a surface of the of the liquid molten evaporation material 12 adjoining the evaporation section 58 from below.

In situations, wherein the evaporator 38 has been heated to a significant operating temperature and in case the evaporation process should be immediately stopped or interrupted the dissipation of respective heat is quite difficult and may require a comparatively long time interval. Here, regulating the evaporation rate only the temperature of the evaporator 38 or evaporation crucible 40 is quite tardy or sluggish.

In the examples of Figs. 5-9 the liquid storage section 57 defines a horizontal cross-sectional area of the evaporation cavity 55 that reduces in size towards the inlet 56 or bottom 42. The cross-sectional area may change gradually or in discrete steps with varying height. The surface of the horizontal cross-sectional area is particularly provided by a specific design of the sidewall 41, in particular by the geometry or design of the lower sidewall section 43.

With the example of Figs. 5 and 7 the lower sidewall section 43 comprises an inclined side wall section, wherein a distance of oppositely located sidewall portions reduces in horizontal direction the closer the respective sidewall portions get to the bottom 42 or inlet 56. As particularly indicated in Figs. 5 and 7, the minimum fill level 74 as well as the maximum for level 75 are located in the inclined or tilted lower sidewall section 43.

Insofar and by modifying the fill level 48 inside the evaporation cavity 55 the total size of an evaporating surface of the liquid molten evaporation material 12 inside the evaporation cavity 55 can be precisely varied. This provides and enables a rather precise control and adjustment of the evaporation rate while keeping the temperature of the evaporator 38 rather constant.

Generally and with the illustrated example a surface normal 59 of the lower sidewall section 43 extends at an angle at an angle $\alpha$ with respect to a horizontal line, wherein $\alpha > 0°$, $\alpha > 10°$, $\alpha > 15°$, $\alpha > 20°$, $\alpha > 30°$, $\alpha > 45°$ or wherein $\alpha > 60°$ and/or wherein $80° > \alpha > 10°$, $70° > \alpha > 20°$, $60° > \alpha > 30°$, $50° > \alpha > 40°$, or wherein $\alpha$ is about 45°.

In the example of Fig. 6 the lower side wall section 43 comprises a curved or concave structure. Here, the angle $\alpha$ between the surface normal 59 and a virtual horizontal line increases towards the bottom 42 and/or towards the inlet 56. In this way, there can be provided a well-defined nonlinear change of the evaporating surface of the liquid molten evaporation material 12 inside the evaporation cavity 55 with a variation of the fill level 48.

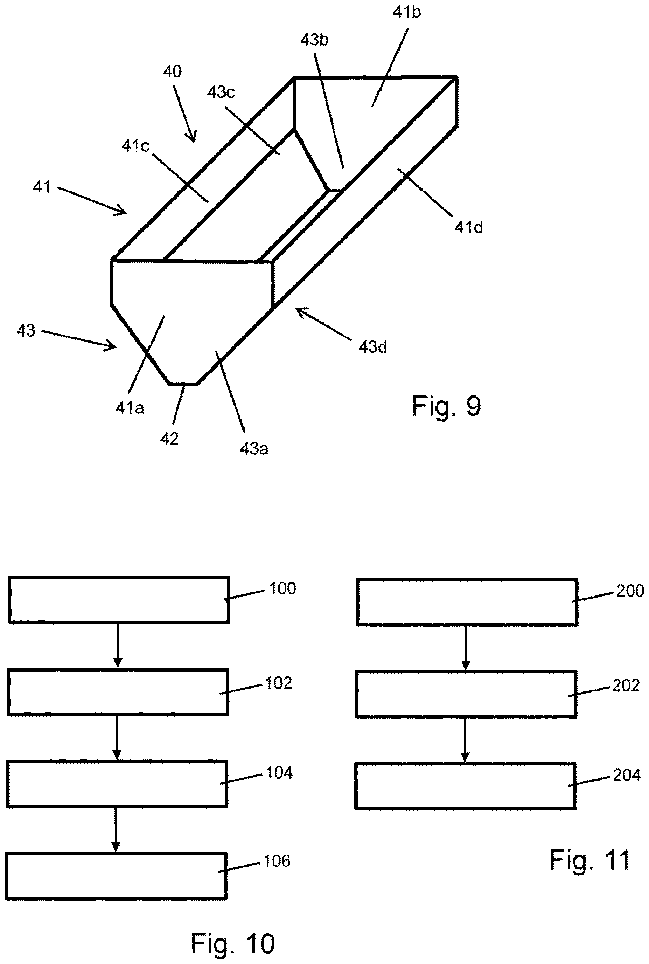

The transverse or horizontal cross-section of the evaporation crucible 40 may be of cylindrical geometry. It may be also of rectangular or oval geometry. In the perspective illustration of Fig. 9, which may correspond with the example of Fig. 7 the evaporation crucible 40 comprises a rectangular cross-section. Here, the sidewall 41 comprises a front face 41a opposite to a back face 41b. The front and back faces 41a, 41b, are connected at their respective opposite ends by longitudinally extending lateral sidewall portion 41c, 41d.

The lower sidewall section 43 comprises a funnel-type converging structure towards the bottom 42. Here, the respective lower portions 43c, 43d, of the lateral sidewall portions 41c, 41d are inclined towards each other and towards the bottom 42. The lower portion of the respective front and back faces 41a, 41b comprise somewhat triangular or trapezoidal structure.

The illustrated geometry is by no way limiting. It is generally conceivable that only one lateral sidewall portion 41c, 43c, 41d, 43d is inclined relative to an oppositely located sidewall portion.

In some examples, the front face 41a is aligned parallel to the back face 41b. In some examples, at least a portion of the front face 41a is inclined relative to the back face 41b. Here, a horizontal distance between the front face 41a and the back face 41b may decrease towards the bottom 42. Insofar and compared to examples, wherein only the sidewalls 41c, 41d are inclined relative to each other and wherein the front face 41a and the back face 41b extend substantially parallel to each other, there can be provided a higher degree of a size reduction of the horizontal cross-sectional area of the evaporation cavity with a decreasing height or level above the bottom 42.

The longitudinal extent of the lateral sidewall portion and hence the larger extent of the lateral sidewall portions 41c, 41d compared to the lateral or horizontal extent of the back and front faces 41a, 41b is beneficial to provide a rather elongated nozzle section 47, which might be beneficial to homogeneously distribute the evaporation material 14 over a comparatively large surface.

The flowchart according to Fig. 10 is illustrative of a method of deriving or determining a fill level of evaporation material inside the evaporation crucible 40. In a first step 100 there is quantitatively measured at least one of a fill level and a mass of molten evaporation material 12 inside the melting crucible 20 and hence outside the evaporation chamber 50. In a second step 102 the vacuum pressure $p_1$ inside the evaporation chamber 50 is determined. In a subsequent step 104 or concurrently with step 102 there is also measured an environmental or atmospheric pressure p2.

From the pressure difference and by having knowledge of the geometry and/or of the position of the melting crucible 20 relative to the evaporation crucible 40 there is derived and/or calculated the fill level 48 of the molten evaporation material 12 inside the evaporation crucible 40 in step 106. In further optional steps there may be also taking into account the temperature of the molten evaporation material 12 inside the melting cavity 23 and/or inside the evaporation cavity 55 to increase precision of the determination of the fill level 48. Due to the temperature dependency of the density of the molten evaporation material 12 a temperature difference between the melting crucible 20 and the evaporation crucible 40 may cause a further offset between the fill level 48 relative to the fill level 28. By measuring the temperatures such effect can be compensated.

Furthermore and in subsequent steps or by way of a control loop of numerous of the above steps the controller 90 may be operable to modify, e.g. to artificially modify the fill level 28 or and/or the height the surface of the molten evaporation material 12 inside the melting crucible 23 by making use of the liquid level adjuster 60, 160. Hence, by raising or lowering the melting crucible 20 relative to ground 1 the fill level 48 of the stationary evaporation crucible 40 can be adjusted and controlled.

In a likewise manner and e.g. when the melting crucible 20 should be stationary arranged relative to the ground 1 the fill level 28 may be artificially modified or controlled by the liquid level adjuster 160, namely by modifying or adjusting an immersion depth of the displacement body 161 in the molten evaporation material 12.

The flowchart according to Fig. 11 is indicative of a further method of adjusting or controlling en evaporation rate of an operation unit 10. Specifically, the method makes use of the evaporation crucible 40 as particularly illustrated in Figs. 5, 6, 7, 8 or 9. There, the evaporation cavity 55 of the evaporation crucible 40 features a horizontal cross-sectional area of a sidewall that reduces towards the inlet 56 or bottom 42 of the evaporation crucible 40. Here and in a first step 200 the evaporation crucible 40 is filled with an amount of molten evaporation material 12, e.g. through the fluid connection 30.

An initial fill level 48 of the molten evaporation material is typically below a maximum fill level 75 and above a minimum level 74. Thereafter or concurrently with initially filling the evaporation crucible 40 in step 202 the temperature of the evaporation cavity 55 is raised or kept at an evaporation temperature at which a substantial portion of the molten evaporation material 12 evaporates in accordance to a first evaporation rate. In step 204 and e.g. based on the above described indirect measurement of the fill level 48 of the molten evaporation material 12 inside the evaporation crucible the fill level 48 inside the evaporation crucible 40 may be reduced in step 204 to vary, i.e. to reduce the surface of the surface of the molten evaporation material 12 adjacent to the evaporation section 58 of the evaporation cavity 55.

By varying, e.g. by increasing or decreasing the size of the evaporation surface of the molten evaporation material 12 inside the evaporation crucible 40, the evaporation rate at which liquefied or molten evaporation material 12 transitions into an evaporated state and turns into evaporated material 14 reduces in accordance to the size reduction of the surface of the molten material incurred with a decreasing of the fill level 48. In the same way, the evaporation rate could be also increased, e.g. by increasing the fill level 48 of the evaporation cavity 55.

Reference Numbers

[0123]

| | |
|---|---|
| 1 | ground |
| 2 | substrate |
| 5 | coating arrangement |
| 10 | evaporation unit |
| 12 | molten material |
| 14 | evaporated material |
| 18 | melting unit |
| 20 | melting crucible |
| 21 | side wall |
| 22 | bottom |
| 23 | melting cavity |
| 24 | carrier |
| 25 | heating |
| 26 | receptacle |
| 27 | insulation |
| 28 | fill level |
| 30 | fluid connection |
| 32 | pipe |
| 33 | end section |
| 34 | end section |
| 35 | heating |
| 36 | flexible portion |
| 38 | evaporator |
| 40 | evaporation crucible |
| 41 | sidewall |
| 42 | bottom |
| 43 | sidewall section |
| 44 | top |
| 45 | heating |
| 46 | outlet |
| 47 | nozzle section |
| 48 | fill level |
| 49 | bottom section |
| 50 | evaporation chamber |
| 51 | chamber wall |
| 52 | vacuum chamber |
| 53 | vacuum pump |
| 55 | evaporation cavity |
| 56 | inlet |
| 57 | liquid storage section |
| 58 | evaporation section |
| 59 | surface normal |

| 60 | liquid level adjuster |
|---|---|
| 61 | lifting device |
| 62 | scissor lift |
| 70 | feeding unit |
| 72 | funnel portion |
| 73 | curved portion |
| 74 | minimum fill level |
| 75 | maximum fill level |
| 80 | measuring arrangement |
| 81 | liquid level detector |
| 82 | distance meter |
| 84 | scale |
| 85 | pressure sensor |
| 86 | temperature sensor |
| 87 | pressure sensor |
| 88 | temperature sensor |
| 90 | controller |
| 94 | fill level sensor |
| 95 | fill level sensor |
| 160 | liquid level adjuster |
| 161 | displacement body |
| 162 | connector |
| 163 | drive |

**Claims**

1. An evaporation crucible (40) for arrangement inside an evaporation chamber (50) and for evaporating a metallic evaporation material, the evaporation crucible (40) comprising:

 - an evaporation cavity (55) comprising a liquid storage section (57) and an evaporation section (58) adjoining the liquid storage section (57) from above, wherein the evaporation cavity (55) is confined by a sidewall (41) and a bottom (42) adjoining the sidewall (41),
 - an inlet (56) in fluid connection with the evaporation cavity (55), extending through or into the bottom (42) and fluidically connectable to a fluid connection (30) to supply a molten evaporation material (12) into the evaporation cavity (55),
 - wherein in the region of the liquid storage section (57) a horizontal cross-sectional area of the evaporation cavity (55) reduces in size towards the inlet (56) or bottom (42).

2. The evaporation crucible (40) according to claim 1, wherein the sidewall (41) comprises a lower sidewall section (43) confining at least a portion of the liquid storage section (57), and wherein the lower sidewall section (43) comprises a horizontal cross-sectional area that reduces in size towards the inlet (56) or bottom (42).

3. The evaporation crucible (40) according to claim 2, wherein the lower sidewall section (43) comprises a funnel-shaped portion (72) with a decreasing cross-sectional area towards the inlet (56) or bottom (42).

4. The evaporation crucible (40) according to claim 2 or 3, wherein the lower sidewall section (43) comprises a curved or concave shaped portion (73) with a decreasing cross-sectional area towards the inlet (56) or bottom (42).

5. The evaporation crucible (40) according to any one of the preceding claims, wherein the lower sidewall section (43) adjoins or merges into the bottom (42).

6. The evaporation crucible (40) according to any one of the preceding claims, wherein the lower sidewall section (43) at least in sections comprises a surface normal (59) extending at an angle $\alpha$ with respect to a horizontal line, wherein $\alpha > 0°$, $\alpha > 10°$, $\alpha > 15°$, $\alpha > 20°$, $\alpha > 30°$, $\alpha > 45°$ or wherein $\alpha > 60°$ and/or wherein $80° > \alpha > 10°$, $70° > \alpha > 20°$, $60° > \alpha > 30°$, $50° > \alpha > 40°$ or wherein $\alpha$ is about $45°$.

7. The evaporation crucible (40) according to any one of the preceding claims, wherein the evaporation crucible (40) is operable to transition molten evaporation material (12) in the liquid storage section (57) into evaporated material (14) evaporating into the evaporation section (58) as long as a fill level of molten evaporation material (12) in the liquid storage section (57) is above a predefined minimum fill level (74) and below a predefined maximum fill level (75).

8. The evaporation crucible (40) according to claim 7, wherein a horizontal cross-sectional area of the sidewall (41) at the predefined maximum fill level (75) is larger than a horizontal cross-sectional area of the sidewall (41) at the predefined minimum fill level (74).

9. The evaporation crucible (40) according to any one of the preceding claims, wherein an evaporation rate, at which molten evaporation material (12) is transitionable into evaporated material (14) inside the evaporation cavity (55), is adjustable by modifying the filling level of the molten evaporation material (12) in the liquid storage section (57).

10. An evaporation unit (10) for evaporating a metallic evaporation material, the evaporation unit (10) comprising:

 - an evaporation crucible (40) according to any one of the preceding claims arranged inside an evaporation chamber (50),
 - a melting crucible (20) outside the evaporation chamber (50) and fluidically connected with the evaporation crucible (40), the melting crucible (20) comprising a melting cavity (23) to melt the metallic evaporation material, to store and/or to heat molten evaporation material (12),
- a liquid level adjuster (60; 160) coupled with at least one of the melting crucible (20) and the evaporation crucible (40) and operable to vary a level of molten evaporation material (12) inside the evaporation cavity (55).

11. An evaporation unit (10) according to claim 10, wherein the liquid level adjuster (60; 160) is coupled with the melting crucible (20) and is operable to vary a level of the molten evaporation material (12) inside the melting cavity (23) with respect to a ground (1) and/or with respect to a sidewall (21) of the melting crucible (20) to thereby vary a filling level of the molten evaporation material (12) in the liquid storage section (57) of the evaporation crucible (40) for adjusting or controlling an evaporation rate, at which molten evaporation material (12) transitions into evaporated material (14) inside the evaporation cavity (55).

12. A coating arrangement (5) for coating a substrate (2) with a metallic material through vapor deposition, the coating arrangement (5) comprising:

   - an evaporation chamber (50) to receive the substrate (2), and
   - an evaporation unit (10) according to claim 10 or 11.

13. A method of adjusting or controlling an evaporation rate of an evaporation unit (10) configured to evaporate a metallic evaporation material, wherein the evaporation unit (10) comprises an evaporation crucible (40) according to any one of the preceding claims 1-9 arranged inside an evaporation chamber (50), the method of adjusting or controlling the evaporation rate comprises:

   - varying a fill level of molten evaporation material (12) in the liquid storage section (57) of the evaporation cavity (55).

14. The method according to claim 13, wherein the evaporation rate, at which molten evaporation material (12) transitions into evaporated material (14) inside the evaporation cavity (55), is raised by increasing the fill level of molten evaporation material (12) in the liquid storage section (58) and wherein the evaporation rate is lowered by decreasing the fill level of molten evaporation material (12) in the liquid storage section (58).

15. The method according to claim 13 or 14, wherein the evaporation unit (10) further comprises a melting crucible (20) outside the evaporation chamber (50) and fluidically connected with the evaporation crucible (40), wherein the fill level of molten evaporation material (12) in the liquid storage section (57) of the evaporation cavity (55) is varied by modifying a level of the molten evaporation material (12) inside a melting cavity (23) of the melting crucible (20) with respect to a ground (1) and/or with respect to a sidewall (21) of the melting crucible (20).

Fig. 1

Fig. 2

Fig. 3

Fig. 4

Fig. 5

Fig. 6

Fig. 7

Fig. 8

Fig. 9

Fig. 10

Fig. 11

Europäisches
Patentamt

European
Patent Office

Office européen
des brevets

# EUROPEAN SEARCH REPORT

Application Number

EP 23 16 7268

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP S63 199868 A (MITSUBISHI HEAVY IND LTD; NISSHIN STEEL CO LTD) 18 August 1988 (1988-08-18) * figures 1, 3 * * the whole document * | 1-15 | INV. C23C14/24 C23C14/54 |
| X | WO 2005/116290 A1 (SIDRABE INC [LV]; YADIN EDGARS [LV] ET AL.) 8 December 2005 (2005-12-08) * page 3, paragraph Summary of the invention; figure 1 * | 1-12 | |
| X | CA 2 824 248 A1 (ARCELORMITTAL INVESTIGACION Y DESARROLLO [ES]) 19 July 2012 (2012-07-19) * paragraphs [0023], [0029] – [0030], [0033] – [0042], [0046], [0049] – [0052], [0057] – [0059]; figure 1 * * abstract * | 1-15 | |

TECHNICAL FIELDS
SEARCHED (IPC)

C23C

The present search report has been drawn up for all claims

| Place of search | Date of completion of the search | Examiner |
|---|---|---|
| The Hague | 24 September 2023 | Engelen, Karen |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...........................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 16 7268

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2023

| Patent document cited in search report | | Publication date | Patent family member(s) | | Publication date |
|---|---|---|---|---|---|
| JP S63199868 | A | 18-08-1988 | NONE | | |
| WO 2005116290 | A1 | 08-12-2005 | CN | 1950541 A | 18-04-2007 |
| | | | DE | 112005001190 T5 | 19-04-2007 |
| | | | JP | 2008500454 A | 10-01-2008 |
| | | | LV | 13383 B | 20-02-2006 |
| | | | WO | 2005116290 A1 | 08-12-2005 |
| CA 2824248 | A1 | 19-07-2012 | AU | 2012206581 B2 | 30-03-2017 |
| | | | BR | 112013018030 A2 | 27-10-2020 |
| | | | CA | 2824248 A1 | 19-07-2012 |
| | | | CN | 103328680 A | 25-09-2013 |
| | | | EP | 2663665 A1 | 20-11-2013 |
| | | | ES | 2538661 T3 | 23-06-2015 |
| | | | HU | E026398 T2 | 28-06-2016 |
| | | | JP | 6046051 B2 | 14-12-2016 |
| | | | JP | 2014505794 A | 06-03-2014 |
| | | | KR | 20140041436 A | 04-04-2014 |
| | | | MX | 342299 B | 23-09-2016 |
| | | | PL | 2663665 T3 | 31-08-2015 |
| | | | RU | 2013137228 A | 20-02-2015 |
| | | | UA | 111602 C2 | 25-05-2016 |
| | | | US | 2014127406 A1 | 08-05-2014 |
| | | | WO | 2012095489 A1 | 19-07-2012 |
| | | | ZA | 201305032 B | 30-07-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3812481 A1